# EUROPEAN PATENT APPLICATION

(11) **EP 4 303 939 A1**
(43) Date of publication of application: **10.01.2024**
(21) Application number: 22763575.2
(22) Date of filing: 02.03.2022
(51) Int. Cl.: H01L 33/08, H01L 33/04, H01L 33/24

(54) **SINGLE-CHIP MULTI-BAND LIGHT-EMITTING DIODE AND METHOD FOR MANUFACTURING SAME**

(30) Priority: 02.03.2021 US 202163155432 P; 28.02.2022 US 202217682614
(71) Applicant: Seoul Viosys Co., Ltd., Ansan-si, Gyeonggi-do 15429 (KR)
(72) Inventor: BAEK, Yong Hyun, Ansan-si Gyeonggi-do 15429 (KR); MIN, Dae Hong, Ansan-si Gyeonggi-do 15429 (KR); KANG, Ji Hun, Ansan-si Gyeonggi-do 15429 (KR)
(74) Representative: Isarpatent
(86) International application number: PCT/KR2022/002925
(87) International publication number: WO 2022/186593

(57) **Abstract**

A light-emitting diode according to one embodiment of the present disclosure comprises: an n-type nitride semiconductor layer; a V-pit formation layer disposed on the n-type nitride semiconductor layer and having V-pits; a sub-light-emitting layer disposed on the V-pit formation layer and having a plurality of well layers and a plurality of capping layers; an active layer disposed on the sub-light-emitting layer and having a first well region formed along a flat surface of the V-pit formation layer and a second well region formed in the V-pit of the V-pit formation layer; and a p-type nitride semiconductor layer disposed on the active layer, wherein an energy bandgap of the sub-light-emitting layer is greater than an energy bandgap of the first well region, and emits light of at least three different peak wavelengths at a single chip level.

## Description

### [Technical Field]

The present disclosure relates to a light emitting diode and a method of fabricating the same, and more particularly, to a light emitting diode emitting light having multi-bands at a single chip level and a method of fabricating the same.

### [Background Art]

Nitride semiconductors are used as light sources for displaying apparatuses, traffic lights, lighting, or optical communication devices, and may be mainly used for light emitting diodes or laser diodes that emit blue or green light. In addition, the nitride semiconductor may be used in a heterojunction bipolar transistor (HBT), a high electron mobility transistor (HEMT), and the like.

In general, a light emitting diode using the nitride semiconductor has a heterojunction structure having a quantum well structure between an N contact layer and a P contact layer. The light emitting diode emits light of a specific wavelength depending on a composition of a well layer in the quantum well structure. To increase internal quantum efficiency and reduce losses due to light absorption, the light emitting diode is designed to emit a spectrum of light having a single peak, i.e. monochromatic light.

It is difficult to implement mixed-color light emitted from lighting, for example, white light as a single-peak monochromatic light. Accordingly, a technique of implementing white light by using a plurality of light emitting diodes together emitting different monochromatic light from one another or by using phosphors converting a wavelength of light emitted from the light emitting diode is generally used.

The use of phosphors is accompanied by a drawback such as a cost of the phosphors themselves or a decrease in efficiency known as Stoke's shift. In addition, it is accompanied by a drawback such as a process drawback of applying phosphors on the light emitting diode and yellowing of a carrier carrying phosphors.

Using a mixture of a plurality of light emitting diodes also complicates the process, and it is inconvenient to prepare the light emitting diodes made of different materials from one another.

Therefore, if light having a spectrum of multi-band can be implemented using a single-chip light emitting diode, the use of the plurality of light emitting diodes may be avoided, and many existing drawbacks may be solved because there is no need to use the phosphors.

There have been attempts to implement light having the spectrum of multi-bands by varying compositions of well layers in a conventional quantum well structure, but it is difficult to generate light having multi-bands because recombination of electrons and holes mainly occurs in a particular well layer. In addition, even when light having multi-band is generated, since independent control according to a wavelength region is difficult, there is a drawback that efficiency is reduced.

### [DISCLOSURE]

### [Technical Problem]

Exemplary embodiments provide a light emitting diode configured to implement light having a spectrum of multi-bands at a single chip level.

Exemplary embodiments provide a novel technology to control relative intensities of multi-bands in a light emitting diode emitting light having a spectrum of multi-bands.

Exemplary embodiments provide a method of fabricating a light emitting diode configured to implement light of desired multi-bands at a single chip level.

### [Technical Solution]

A light emitting diode according to an exemplary embodiment of the present disclosure includes: an n-type nitride semiconductor layer; a V-pit generation layer disposed on the n-type nitride semiconductor layer and having V-pits; a sub-emission layer disposed on the V-pit generation layer and having a plurality of well layers and a plurality of capping layers; an active layer disposed on the sub-emission layer and having a first well region formed along a flat surface of the V-pit generation layer and a second well region formed in the V-pit of the V-pit generation layer; and a p-type nitride semiconductor layer disposed on the active layer, in which an energy band gap of the sub-emission layer is wider than that of the first well region, and the light emitting diode emits light having at least three different peak wavelengths at a single chip level.

The sub-emission layer may emit blue light or green light.

The plurality of well layers may emit light having a peak wavelength within a region of wavelengths shorter than a peak wavelength of light emitted from the first well region, and may emit light having a peak wavelength within a region of wavelengths longer than a peak wavelength of light emitted from the second well region.

The well layer of the sub-emission layer may include a first well layer, a second well layer, and a third well layer.

Energy band gaps of the first well layer, the second well layer, and the third well layer may be substantially identical to one another, and may be wider than that of the first well region, and narrower than that of the second well region.

At least one of the first through third well layers may have an energy band gap different from those of other well layers.

The plurality of well layers may emit light having a peak wavelength within the region of wavelengths longer than the peak wavelength of light emitted from the second well region, and may emit light having a peak wavelength within the region of wavelengths shorter than the peak wavelength of light emitted from the first well region.

An energy band gap of the third well layer may be narrower than those of the first well layer, the second well layer, and the second well region, and may be wider than that of the first well region.

The energy band gap of the third well layer may have an energy band gap wider than those of the first well layer, the second well layer, and the active layer.

The active layer may emit light having at least two different peak wavelengths at a single chip level.

The first well region may emit light having a peak wavelength within a region of wavelengths longer than that of light emitted from the second well region.

The first well region may emit yellow light, and the second well region may emit blue light.

A light emitting diode according to another exemplary embodiment of the present disclosure includes an n-type nitride semiconductor layer; a V-pit generation layer disposed on the n-type nitride semiconductor layer and having V-pits; a sub-emission layer disposed on the V-pit generation layer and having a plurality of well layers and a plurality of capping layers; an active layer disposed on the sub-emission layer and having a first well region formed along a flat surface of the V-pit generation layer and a second well region formed in the V-pit of the V-pit generation layer; and a p-type nitride semiconductor layer disposed on the active layer, in which the light emitting diode emits light having at least three different peak wavelengths at a single chip level, and an intensity of light at a peak wavelength disposed in a middle among the at least three different peak wavelengths is located between intensities of light at peak wavelengths disposed at both sides.

In an exemplary embodiment, the intensities at the at least three different peak wavelengths may increase as the wavelength increases.

In another exemplary embodiment, the intensities at the at least three different peak wavelengths may decrease as the wavelength increases.

A full width at half maximum of an emission spectrum band including a longest wavelength among the at least three different peak wavelengths may be greater than those of emission spectrum bands including other peak wavelengths.

An emission spectrum band including a shortest wavelength among the at least three different peak wavelengths may have a left-right asymmetric shape.

A peak wavelength disposed in the middle among the at least three different peak wavelengths may be closer to a shorter peak wavelength adjacent thereto than a longer peak wavelength adjacent thereto.

The at least three different peak wavelengths may have a shortest peak wavelength and a longest peak wavelength, and an intensity change as the wavelengths increase from the longest peak wavelength to the longer wavelength may be more gradual than an intensity change as the wavelengths decrease from the shortest peak wavelength to the shorter wavelength.

At least two valleys may be formed between the at least three different peak wavelengths, and the at least two valleys may have different intensities from each other.

### [Description of Drawings]

FIG. 1 is a schematic cross-sectional view illustrating a light emitting diode according to an exemplary embodiment.
FIG. 2A is a schematic partial cross-sectional view showing an enlarged portion of FIG. 1.
FIG. 2B is a schematic partial cross-sectional view showing an enlarged view of a sub-emission layer of FIG. 2A.
FIG. 3A and FIG. 3B are diagrams showing an energy band diagram of FIG. 2A.
FIG. 4 is a graph showing optical characteristics of a light emitting diode according to an exemplary embodiment.
FIG. 5 is a schematic cross-sectional view illustrating a light emitting diode according to another exemplary embodiment.
FIG. 6A and FIG. 6B are diagrams showing an energy band diagram of FIG. 5.
FIG. 7 is a graph showing optical characteristics of the light emitting diode according to FIG. 5
FIG. 8 is a schematic cross-sectional view illustrating a light emitting diode according to another exemplary embodiment.
FIG. 9A and FIG. 9B are diagrams showing an energy band diagram of FIG. 8.
FIG. 10 is a graph showing optical characteristics of the light emitting diode according to FIG. 8
FIG. 11 is a schematic cross-sectional view illustrating a lateral type light emitting device according to an exemplary embodiment.
FIG. 12 is a schematic cross-sectional view illustrating a lateral type light emitting device according to another exemplary embodiment.
FIG. 13 is a schematic cross-sectional view illustrating a flip-chip type light emitting device according to another exemplary embodiment.
FIG. 14 is a schematic cross-sectional view illustrating a light emitting module according to an exemplary embodiment.
FIG. 15A is a perspective view illustrating a light emitting diode package to which a light emitting diode according to an exemplary embodiment is applied.
FIG. 15B is a plan view of FIG. 15A.
FIG. 15C is a cross-sectional view taken along line I-I' of its corresponding plan view shown in FIG. 15B.

### [Detailed Description of the Illustrated Embodiments]

Hereinafter, exemplary embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the exemplary embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

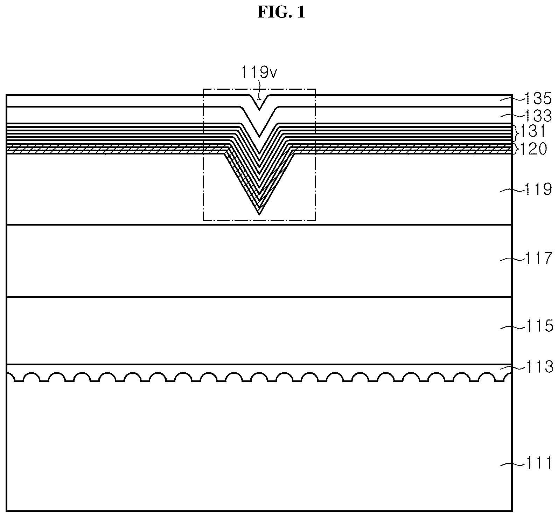

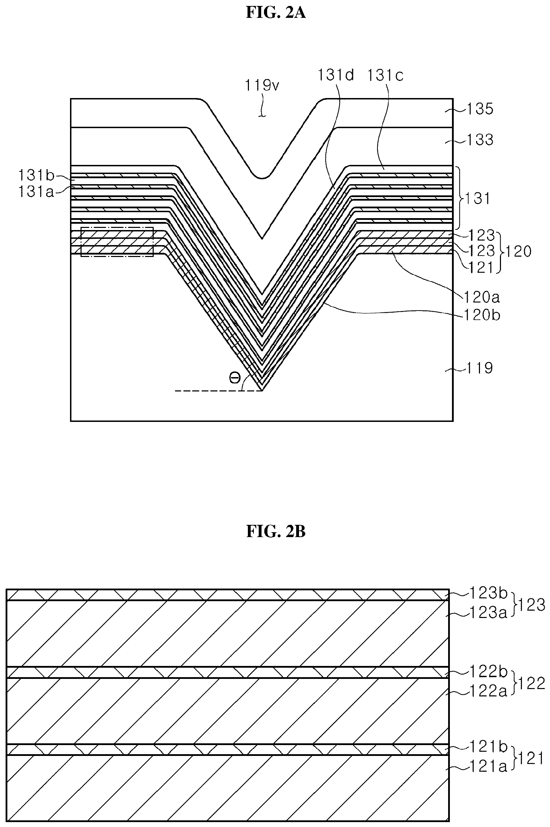

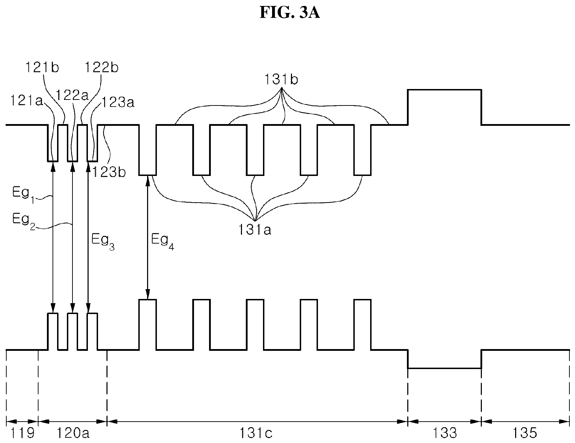

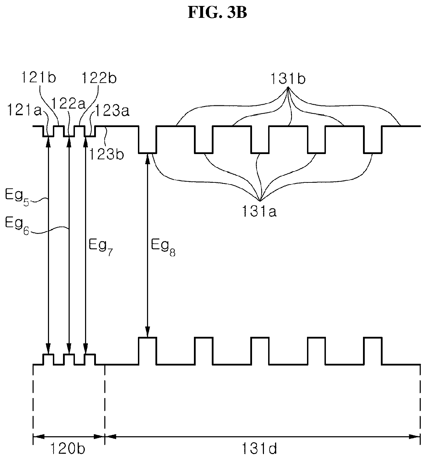

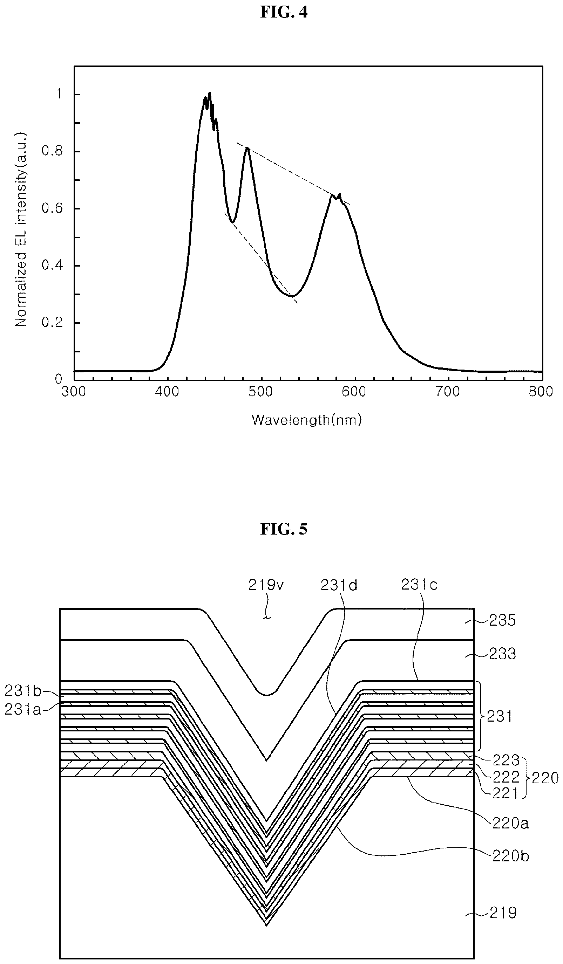

FIG. 1 is a schematic cross-sectional view illustrating a light emitting diode according to an exemplary embodiment, FIG. 2A is a schematic partial cross-sectional view showing an enlarged portion of FIG. 1, FIG. 2B is a schematic partial cross-sectional view showing an enlarged view of a sub-emission layer of FIG. 2A, FIG. 3A and FIG. 3B are diagrams showing an energy band diagram of FIG. 2A, and FIG. 4 is a graph showing optical characteristics of the light emitting diode according to an exemplary embodiment.

Referring to FIG.1, FIG. 2A, and FIG. 2B, the light emitting diode may include a substrate 111, a nucleation layer 113, a high-temperature buffer layer 115, an n-type nitride semiconductor layer 117, and a V-pit generation layer 119, a sub-emission layer 120, an active layer 131, an electron blocking layer 133, and a p-type nitride semiconductor layer 135.

The substrate 111 is for growing a gallium nitride-based semiconductor layer, and a sapphire substrate, a SiC substrate, a Si substrate, a GaN substrate, a spinel substrate, and the like may be used. The substrate 111 may have protrusions as shown in FIG.1, and may be, for example, a patterned sapphire substrate. However, the inventive concepts are not limited thereto, and for example, the substrate 111 may be a substrate having a flat upper surface, such as a flat sapphire substrate.

The nucleation layer 113 may be formed on the substrate 111. The nucleation layer 113may be formed of (Al, Ga)N at a low temperature of 400 °C to 600 °C, and for example, may be formed of AlGaN or GaN. A composition of the nucleation layer 113 may be changed depending on the substrate 111. For example, when the substrate 111 is a patterned sapphire substrate, the nucleation layer 113 may be formed of AlGaN, and when the substrate 111 is a sapphire substrate having a flat upper surface, the nucleation layer 113 may be formed of GaN. The nucleation layer 113 may be formed to have a thickness of about 25 nm.

The high-temperature buffer layer 115 may be formed on the nucleation layer 113. The high-temperature buffer layer 115 may be grown at a relatively high temperature so as to alleviate an occurrence of defects such as dislocations between the substrate 111 and the n-type nitride semiconductor layer 117. The high-temperature buffer layer 115 may be formed of undoped GaN or GaN doped with n-type impurities. While the high-temperature buffer layer 115 is formed, a threading dislocation may be generated due to a lattice mismatch between the substrate 111 and the high-temperature buffer layer 115.

The n-type nitride semiconductor layer 117 may be formed on the high-temperature buffer layer 115. The n-type nitride semiconductor layer 117 may be a nitride-based semiconductor layer doped with n-type impurities, for example, a nitride semiconductor layer doped with Si. A doping concentration of Si doped into the n-type nitride semiconductor layer 117 may be 5E17/cm³ to 5E19/cm³. The n-type nitride semiconductor layer 117 may be grown under a growth pressure of 150 Torr to 200 Torr at 1000 °C to 1200 °C (e.g., 1050 °C to 1100 °C) by supplying metal source gases into a chamber using MOCVD technology. In this case, the n-type nitride semiconductor layer 117 may be continuously formed on the high-temperature buffer layer 115, and a threading dislocation D formed in the high-temperature buffer layer 115 may be transferred to the n-type nitride semiconductor layer 117. The n-type nitride semiconductor layer 117 may be formed to be relatively thinner than the high-temperature buffer layer 115, for example, to have a thickness of about 2.5 µm.

The V-pit generation layer 119 may be formed in an upper portion of the n-type nitride semiconductor layer 117. The V-pit generation layer 119 may be formed of, for example, a GaN layer. The V-pit generation layer 119 may be grown at a relatively lower temperature than that of the n-type nitride semiconductor layer 117, for example, about 900 °C, and thus, V-pits 119v may be formed in the V-pit generation layer 119.

Since the V-pit generation layer 119 is grown at the relatively lower temperature than that of the n-type nitride semiconductor layer 117, a crystal quality may be artificially deteriorated and a three-dimensional growth may be promoted to generate the V-pits 119v. The V-pits 119v may have a hexagonal pyramid shape when a growth plane of the nitride semiconductor layer is a c-plane. The V-pits 119v may be formed at an upper end of the threading dislocation.

The V-pit generation layer 119 may be formed to have a thickness smaller than that of the n-type nitride semiconductor layer 117, for example, to have a thickness of about 450 nm to 600 nm. Sizes of the V-pits 119v formed in the V-pit generation layer 119 may be adjusted through a growth condition and the like of the V-pit generation layer 119. In the exemplary embodiment of the present disclosure, the sizes of the V-pits 119v formed in the V-pit generation layer 119 may affect generation of light having a multi-band spectrum. In the exemplary embodiment of the present disclosure, the V-pit generation layer 119 is described as a single layer, without being limited thereto, or may be a multi-layer. For example, the V-pit generation layer 119 may include at least two layers among GaN, AlGaN, InGaN, or AlGaInN layers.

The sub-emission layer 120 may be disposed on the V-pit generation layer 119. The sub-emission layer 120 may emit light having a predetermined energy by recombination of electrons and holes. In the exemplary embodiment of the present disclosure, the sub-emission layer 120 may include a first well layer 121a in contact with the V-pit generation layer 119, a third well layer 123a in contact with the active layer 131, and a second well layer 122a disposed between the first well layer 121a and the third well layer 123a. However, the inventive concepts are not limited thereto, and the sub-emission layer 120 may be formed of at least one well layer. The first, second, and third well layers 121a, 122a, and 123a may include a nitride semiconductor layer such as InₓAl_{y}Ga_{1-x-y}N (0≤x≤1, 0≤y≤1), for example, InGaN.

Referring to FIG. 2B, the sub-emission layer 120 may further include capping layers 121b, 122b, and 123b, which are disposed on the well layers 121a, 122a, and 123a of the sub-emission layer 121, respectively. The capping layers 121b, 122b, and 123b may be formed of, for example, AlGaN or AlInGaN, and may function as capping with band gaps wider than those of the well layers 121a, 122a, and 123a of the sub-emission layer 120. The capping layers 121b, 122b, and 123b may be formed so as to prevent dissociation of In in the well layers 121a, 122a, and 123a of the sub-emission layer 120 while the well layers 121a, 122a, and 123a of the sub-emission layer 120 or the active layer 131 are grown. As such, in the light emitting diode according to the illustrated exemplary embodiment, the capping layers 121b, 122b, and 123b may also function as barrier layers, and thus, the sub-emission layer 120 may not include a separate barrier layer, thereby reducing a thickness of the light emitting diode.

The sub-emission layer 120 may be formed along an adjacent V-pit generating layer 119, and may include a first sub-emission region 120a formed over a flat surface of the V-pit generation layer 119 and a second sub-emission region 120b formed in the V-pit 119v. The sub-emission layer 120 may have a flat plane disposed between a plurality of convex regions formed on the substrate 111 and a growth plane forming an acute angle 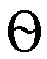 . The growth plane forming the acute angle 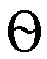 may be formed between the c-plane and an m-plane. In addition, a distance between the growth plane forming the acute angle and a side surface of the light emitting diode may decrease as it approaches the p-type nitride semiconductor layer 135.

An inclined surface in the V-pit 119v may have a relatively low growth rate, and accordingly, a thickness of the second sub-emission region 120b formed on the inclined surface in the V-pit 119v may be formed to be smaller than that of the first sub-emission region 120a. The second sub-emission region 120b may have a left-right symmetric structure. In addition, a point where inclined surfaces of the second sub-emission region 120b intersect may be disposed over a convex portion of the substrate 111 so as to overlap one of the convex portions of the substrate 111. The second sub-emission region 120b may be parallel to a second well region 131d of the active layer 131.

The thickness of the second sub-emission region 120b in the V-pit 119v may vary depending on a size of the V-pit 119v. The size of the V-pit 119v may be adjusted by adjusting a growth time, a growth temperature, and the like of the V-pit generation layer 119. In addition, a well layer included in the second sub-emission region 120b may be formed of InGaN having an In content lower than that of a well layer included in the first sub-emission region 120a, and the second sub-emission region 120b may not emit light because the In content thereof is too small, without being limited thereto, or it may emit light depending on driving conditions.

In addition, Al compositions contained in the capping layers 121b, 122b, and 123b in the first sub-emission region 120a disposed over the flat surface of the V-pit generation layer 119 may be different from those contained in the capping layers 121b, 122b, and 123b in the second sub-emission region 120b. For example, the Al compositions contained in the capping layers in the first sub-emission region 120a may be greater than those contained in the capping layers in the second sub-emission region 120b.

The sub-emission layer 120 may be grown at a relatively lower temperature than that of growing the V-pit generation layer 119, and may be grown at, for example, 700 °C to 800 °C. The sub-emission layer 120 may have various energy band gaps depending on growth conditions.

The active layer 131 may be formed on the sub-emission layer 120. The active layer 131 may emit light having a predetermined energy by recombination of electrons and holes. The active layer 131 may have a single quantum well structure or a multi quantum well (MQW) structure in which quantum barrier layers and quantum well layers are alternately stacked. The quantum barrier layer may be formed of a nitride semiconductor layer such as GaN, InGaN, AlGaN, AlInGaN, or the like having a band gap wider than that of the quantum well layer.

The active layer 131 may include a well layer 131a and a barrier layer 131b, and may be formed in contact with the sub-emission layer 120, without being limited thereto. A plurality of well layers 131a may be disposed apart from one another at a regular interval. The active layer 131 may be formed along the V-pits 119v, and the active layer 131 may include a first well region 131c grown along a flat upper surface of the V-pit generation layer 119 and a second well region 131d grown in the V-pit 119v. A thickness of the second well region 131d of the active layer 131 may be smaller than that of the first well region 131c of the active layer 131. The thickness of the second well region 131d in the V-pit 119v may vary depending on the size of the V-pit 119v.

Meanwhile, the well layer 131a may be formed of InₓAl_{y}Ga_{1-x-y}N (0≤x≤1, 0≤y≤1), and composition ratios of In, Al, and Ga may be selected depending on required light. The barrier layer 131b may be formed of a nitride semiconductor layer such as GaN, InGaN, AlGaN, AlInGaN, or the like which has an energy band gap wider than that of the well layer 131a. For example, when the first well region 131c is formed of InGaN so as to emit yellow light, the barrier layer 131b may be formed of InGaN having an In content lower than that of the well layer 131a.

A capping layer (not shown) may be interposed between the well layer 131a and the barrier layer 131b. The capping layer may be formed before growing the barrier layer 131b so as to prevent dissociation of In in the well layer 131a while the barrier layer 131b is grown. The capping layer may include Al, and for example, may be formed of AlGaN or AlInGaN. An Al composition contained in a first capping layer portion, that is, a capping layer portion disposed over the flat surface of the V-pit generation layer 119 may be different from that in a second capping layer portion, that is, a capping layer portion formed in the V-pit 119v. An Al content in the first capping layer portion may be greater than that in the second capping layer portion. For example, the Al composition in the first capping layer portion may be 10 atomic % or more, further 12 atomic % or more with respect to a total composition in the capping layer, and the Al composition in the second capping layer portion may be about 5 atomic% or more with respect to the total composition in the capping layer.

The first well region 131c may have a composition for emitting light having a longer wavelength spectrum of multi-bands, and the second well region 131d may have a composition for emitting light having a shorter wavelength spectrum of multi-bands. For example, the first well region 131c may be formed of InₓAl_{y}Ga_{1-x-y}N (0≤x≤1, 0≤y≤1) so as to emit yellow light having a wavelength of 560 nm to 590 nm, and the second well region 131d may be formed of InₓAl_{y}Ga_{1-x-y}N (0≤x≤1, 0≤y≤1) so as to emit blue or green light having a wavelength of 400 nm to 500 nm, without being limited thereto. When a combination of wavelengths of light emitted from the first well region 131c and the second well region 131d is a combination of emitting white light, light emitted from the first well region 131c and the second well region 131d may be emitted with wavelengths of different regions.

The second well region 131d may be formed on each surface of the V-pit 119v to have a same composition, without being limited thereto, or may be formed to have a different composition on each surface. Accordingly, the light emitting diode of the present disclosure may implement light having at least two bands at a single chip level using the first well region 131c and the second well region 131d. Accordingly, white light having a correlated color temperature (CCT) within a range of 3000K to 7000K may be displayed, and the CCT may be appropriately adjusted depending on an intended use.

An electron blocking layer 133 may be formed on the active layer 131. The electron blocking layer 133 layer may be formed of, for example, a p-type AlGaN, without being limited thereto, or may be formed of AlInGaN or the like. The electron blocking layer 133 may also be formed in the V-pit 119v. The p-type AlGaN of the electron blocking layer 133 may be expressed by General Formula AlₓGa₁₋ₓN, where x may be greater than 0 and less than 0.3. Meanwhile, in the exemplary embodiment of the present disclosure, a thickness of the electron blocking layer 133 may be less than about 100 nm.

The electron blocking layer 133 may perform an electron blocking function by adjusting an energy band gap and at the same time, may effectively prevent current leakage. The electron blocking layer 133 has a relatively wide energy band gap and prevents electron overflow to increase an electron recombination rate.

The p-type nitride semiconductor layer 135 may be formed on the electron blocking layer 133. The p-type nitride semiconductor layer 135 may be formed of a semiconductor layer doped with p-type impurities such as Mg, for example, GaN. The p-type nitride semiconductor layer 135 may be a single layer or a multi-layer, and may include a p-type contact layer. The p-type nitride semiconductor layer 135 may have a concave groove in the V-pit 119v. Since the p-type nitride semiconductor layer 135 has the concave groove on the V-pit 119v, a path through which light emitted from the second well region 123d passes through the p-type nitride semiconductor layer 135 may be shortened, and thus, light loss due to the p-type nitride semiconductor layer 135 may be reduced.

Referring to FIGS. 3A and 3B, FIG. 3A shows an energy band diagram of the first sub-emission region 120a of the sub-emission layer 120 grown along the flat surface of the V-pit generation layer 119 and the first well region 131c of the active layer 131, and FIG. 3B shows an energy band diagram of the second sub-emission region 120b of the sub-emission layer 120 grown along the V-pit 119v generated by the V-pit generation layer 119 and the second well region 131d of the active layer 131. In the illustrated exemplary embodiment, the first, second, and third well layers 121a, 122a, and 123a of the sub-emission layer 120 are all grown at a same temperature, and thus, may have same energy band gaps Eg1, Eg2, and Eg3. However, the inventive concepts are not limited thereto, and in another exemplary embodiment, at least one well layer may be grown under a temperature condition different from those of the other two well layers, and thus, at least one of the energy band gaps Eg1, Eg2, and Eg3 of the well layers 121a, 122a, and 123a may be different from other band gaps.

When the sub-emission layer 120 is grown, sizes of the energy band gaps may vary depending on In contents, and for example, an In content of the sub-emission layer 120 may be smaller than that of the first well region 131c of the active layer 131, and may be greater than that of the second well region 131d of the active layer 131. Accordingly, the energy band gaps Eg1, Eg2, and Eg3 of the first, second, and third well layers 121a, 122a, and 123a of the sub-emission layer 120 may be greater than an energy band gap Eg4 of the first well region 131c, and may be smaller than an energy band gap Eg8 of the second well region 131d.

In addition, the sub-emission layer 120 may have a composition for emitting light having a shorter wavelength spectrum of the multi-bands than that of the first well region 131c, and may have a composition for emitting light having a longer wavelength spectrum of the multi-bands than that of the second well region 131d.

The energy band gaps of the first, second, and third well layers 121a, 122a, and 123a of the sub-emission layer 120 and the well layer 131a of the active layer 131 may have band gaps smaller than those of other layers disposed on both sides of the sub-emission layer 120 and the active layer, for example, the n-type nitride semiconductor layer 117, the high-temperature buffer layer 115, the p-type nitride semiconductor layer 135, and the electron blocking layer 133 or the substrate 111. Accordingly, even when light generated in the sub-emission layer 120 and the active layer 131 passes through the other layers so as to be emitted to the outside of the semiconductor layer, light may be emitted to the outside without light absorption and loss.

In addition, since there is no light absorption and loss, the layers disposed on the both sides of the sub-emission layer 120 and the active layer 131 help light of a plurality of wavelength bands to be mixed and emitted. That is, even when light having different wavelengths is generated in the sub-emission layer 120 and the active layer 131, colors of light having different wavelengths may not be distinguished when light is emitted to the outside of the light emitting diode. Light generated in each of the sub-emission layer 120 and the active layer 131 may be emitted after sufficiently mixed in other layers disposed on the both sides of the sub-emission layer 120 and the active layer 131, and thus, light emitted to the outside of the light emitting diode may exhibit color coordinates of mixed light, thereby implementing white light.

For example, light generated from the sub-emission layer 120 and the active layer 131 may be mixed in the n-type nitride semiconductor layer 117, the high-temperature buffer layer 115, the substrate 111, the electron blocking layer 133, and the p-type nitride semiconductor layer 135. In particular, the substrate 111 or the n-type nitride semiconductor layer 117 may be formed to have a thickness sufficient for light to be mixed, and thus, may be more effective in forming white light. In addition, since the sub-emission layer 120 and the active layer 131 are disposed close to each other, light loss may be minimized until light of different wavelengths are mixed with one another.

Furthermore, since the sub-emission layer 120 and the active layer 131 receive current through a common n-electrode and a common p-electrode, a uniform current may be supplied to the sub-emission layer 120 and the active layer 131 such that a difference and a change of the current supply are small. Accordingly, even when current on/off occurs or the light emitting diode is driven for a long period of time, an intensity ratio of light emitted from the sub-emission layer 120 and the active layer 131 may be maintained, and thus, a color coordinate range of white light may be constantly maintained.

FIG. 4 is a graph showing an electroluminescence (EL) intensity of the light emitting diode fabricated according to an exemplary embodiment of the present disclosure.

Here, the first well region 131c is formed of InₓAl_{y}Ga_{1-x-y}N (0≤x≤1, 0≤y≤1) so as to emit yellow light having a central wavelength of 560 nm to 590 nm, and the sub-emission layer 120 is formed of InₓAl_{y}Ga_{1-x-y}N (0≤x≤1, 0≤y≤1) emitting blue or green light having a wavelength of 400 nm to 500 nm, which has an In content smaller than that of the first well region 131c, and greater than that of the second well region 131d.

According to the illustrated exemplary embodiment, the active layer 131 may emit light having at least two bands. However, since the first well region 131c and the second well region 131d are formed together in a same process, it may be difficult to control a thickness and an In composition of the second well region 131d of the active layer 131 that emits light having a shorter wavelength. That is, since an In content in the second well region 131d is substantially dependent on an In content in the first well region 131c, it may be difficult to control a peak wavelength and an intensity of light within a shorter wavelength region emitted from the second well region 123d.

On the contrary, since the sub-emission layer 120 may be grown under a condition different from that of the active layer 131, an In composition and a thickness of the sub-emission layer 120 may be freely adjusted. Accordingly, by disposing the sub-emission layer 120, it is possible to independently control the peak wavelength within a desired shorter wavelength region, and it is possible to increase an intensity of light within a corresponding wavelength region. The sub-emission layer 120 may have a composition for emitting light having a wavelength shorter than that of the active layer 131. A peak wavelength of blue emitted from the first sub-emission region 120a of the sub-emission layer 120 and a peak wavelength of blue emitted from the second well region 131d of the active layer 131 may be within a region of a similar wavelength band, and a cold white color having a correlated color temperature of about 6500K with a stronger intensity may be implemented, compared to a light emitting diode including each of them alone.

Accordingly, the light emitting diode of the illustrated exemplary embodiment may implement light having at least three peak wavelengths at a single chip level through at least two peak wavelengths of light emitted from the active layer 131 and at least one peak wavelength of light emitted from the sub-emission layer 120, and the peak wavelength band of the emitted light may be adjusted.

As shown in FIG. 4, three peak wavelengths are observed in the spectrum of light emitted from the light emitting diode, and among these peak wavelengths, an intensity of light at a shortest peak wavelength may be highest, and an intensity of light at a longest peak wavelength may be the smallest. That is, as magnitudes of the peak wavelengths increase, the intensity of light may decrease.

In addition, a peak wavelength disposed in a middle among the three peak wavelengths may be closer to a shorter peak wavelength adjacent thereto than a longer peak wavelength adjacent thereto. Furthermore, valleys are formed between the at least three peak wavelengths, and a slop of a line connecting the valleys may be in a same direction as that of a line connecting intensities at the peak wavelengths. That is, as shown in FIG. 4, the line connecting the valleys has a decreasing slope same as a slop of the line connecting the intensities at the peak wavelengths as the wavelength increases.

Meanwhile, an intensity change as the wavelength increases from the longest peak wavelength to the longer wavelength side may be smaller than an intensity change as the wavelength decreases from the shortest peak wavelength to the shorter wavelength side. For example, a full width at half maximum of a spectrum of light emitted from a longer wavelength region, that is, a yellow region, may be larger than that of a spectrum of light emitted from other regions. Since a wavelength band of light emitted in the longer wavelength region is wide, it is effective in converting white light.

Meanwhile, the In contents may increase in an order of the V-pit generation layer 119, the sub-emission layer 120, and the active layer 131. Accordingly, it is possible to reduce the transfer of stress and strain generated by a lattice mismatch between the nitride semiconductor layer and the substrate 111 to the active layer 131, and propagation of defects such as dislocations to the active layer 131 may be prevented. The sub-emission layer 120 may not only emit light, but may also relieve stress caused by the lattice mismatch. A lattice constant of the sub-emission layer 120 may have a value intermediate that is between a lattice constant of the V-pit generation layer 119 and a lattice constant of the active layer 131, and thus, the sub-emission layer 120 may reduce a difference in the lattice constants between the V-pit generation layer 119 and the active layer 131. Accordingly, a crystal quality of the active layer 131 may be improved by the sub-emission layer 120. The sub-emission layer 120 may function as a superlattice layer for reducing the difference in lattice constants. In an exemplary embodiment, the light emitting diode may further include a superlattice layer between the V-pit generation layer 119 and the active layer 131 in addition to the sub-emission layer 120.

The light emitting diode may have a first exiting surface and a second exiting surface on the upper and lower portions of the substrate 111, respectively, where light generated in the sub emission layer 120 and the active layer 131 is emitted. That is, light generated from the sub-emission layer 120 and the active layer 131 may be emitted upward from the substrate 111 through the first exiting surface, or may be emitted downward from the substrate 111 through the second exiting surface opposite to the first exiting surface.

For light within a shorter wavelength region emitted from the sub-emission layer 120, an extraction efficiency of light emitted to the second exiting surface may be higher than that of light emitted to the first exiting surface. This is related to the energy band gaps of the active layer 131 emitting light of a longer wavelength and the sub-emission layer 120 emitting light of a shorter wavelength.

Since the active layer 131 having the energy band gap shallower than the energy band gap Eg1, Eg2, and Eg3 of the sub-emission layer 120 is disposed adjacent to the p-type nitride semiconductor layer 135, most of holes injected from the p-type nitride semiconductor layer 135 may be recombined in the active layer 122 due to a higher barrier for the holes injected from the p-type nitride semiconductor layer 135, and a recombination rate in the sub-emission layer 120 decreases, thereby reducing radiation efficiency. In addition, since the well layers of the sub-emission layer 120 have the energy band gaps Eg1, Eg2, and Eg3 that are wider than the energy band gaps Eg4 of the well layers of the active layer 131, a portion of light generated in the sub-emission layer 120 may be absorbed by the active layer 131. Accordingly, a structure of the light emitting diode according to the exemplary embodiment of the present disclosure may be suitable for a light emitting diode having a vertical structure or a flip-chip type structure that emits light through the second exiting surface in the lower portion of the substrate 111 so as to reduce light loss.

In other exemplary embodiments below, so as to avoid repeated descriptions, differences from the above-described embodiments will be mainly described, and same elements will be briefly described or omitted.

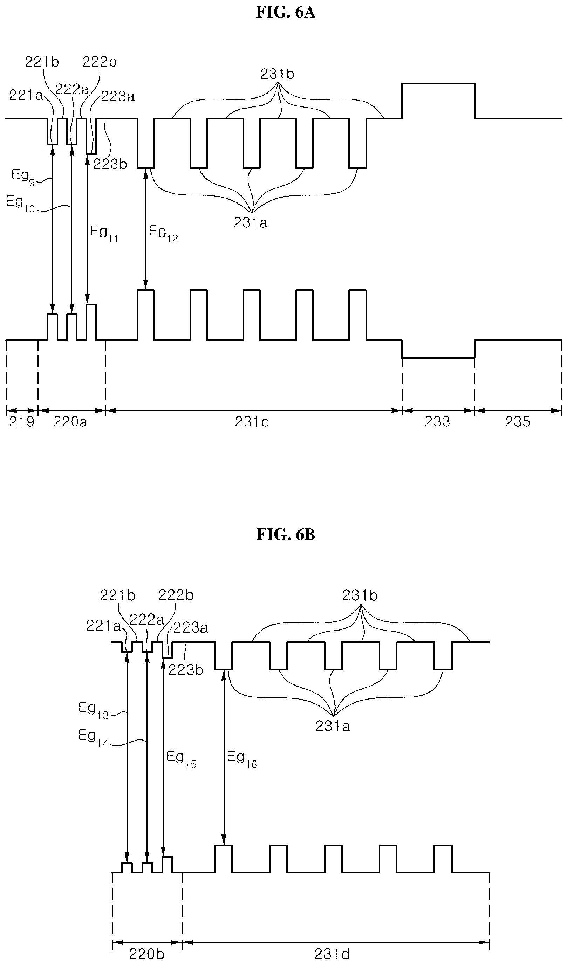

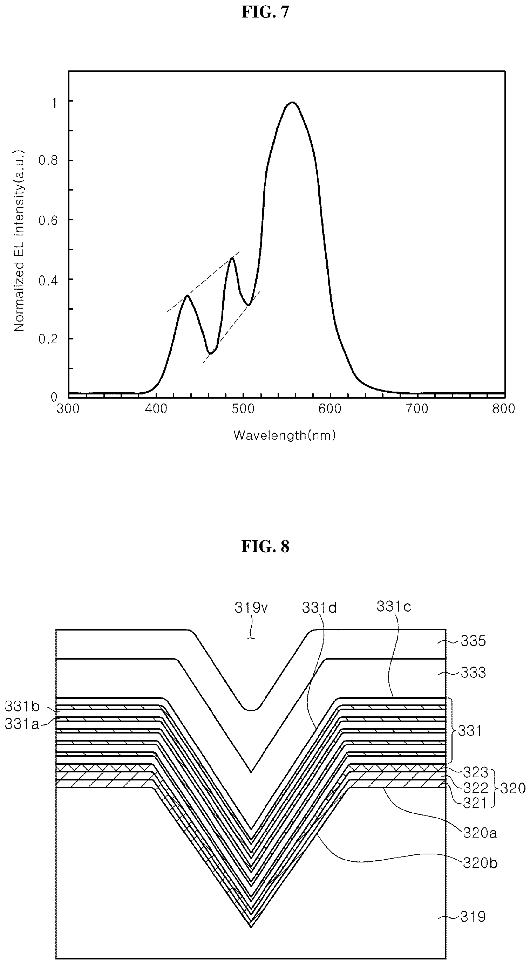

FIG. 5 is a schematic cross-sectional view illustrating a light emitting diode according to another exemplary embodiment, FIG. 6A and FIG. 6B are diagrams showing an energy band diagram of FIG. 5, and FIG. 7 is a graph showing optical characteristics of the light emitting diode according to FIG. 5.

Referring to FIG. 5, the light emitting diode according to the illustrated exemplary embodiment is similar to the light emitting diode of the exemplary embodiment of FIG. 1 except for an energy band gap of a third well layer 223a of a sub-emission layer 220. The light emitting diode according to the illustrated exemplary embodiment, which is similar to the light emitting diode of the embodiment of FIG. 1, may include a V-pit generation layer 219, an active layer 231, a sub-emission layer 220, an electron blocking layer 233, and a p-type nitride-based semiconductor layer 235. In addition, although not shown, the light emitting diode may include a substrate, a nucleation layer, a high-temperature buffer layer, and an n-type nitride semiconductor layer. The active layer 231 may include a well layer 231a and a barrier layer 231b, and the sub-emission layer 220 may include first through third well layers 221a, 222a, and 223a and capping layers 221b; 222b, and 223b. In an exemplary embodiment, the sub-emission layer 220 may include the first well layer 221a in contact with the V-pit generation layer 219, the third well layer 223a in contact with the active layer 231, and the second well layer 222a disposed between the first well layer 221a and the third well layer 223a.

The sub-emission layer 220 may be grown at a temperature relatively lower than that of growing the V-pit generation layer 219, and may be grown at a temperature relatively higher than that of growing the active layer 231. The sub-emission layer 220 may be grown at 700 °C to 800 °C. The sub-emission layer 220 may have various energy band gaps depending on growth temperatures. In an exemplary embodiment, a growth temperature of at least one of the first, second, and third well layers 221a, 222a, and 223a may be set to be different. For example, the third well layer 223a may be grown at a temperature about 20 °C lower than those of growing the first and second well layers 221a and 222a.

FIG. 6A shows an energy band diagram of a first sub-emission region 220a of the sub-emission layer 220 formed on a flat surface of the V-pit generation layer 219 and a first well region 231c of the active layer 231, and FIG. 6B shows an energy band diagram of a second sub-emission region 220b of the sub-emission layer 220 in a V-pit 219v and a second well region 231d of the active layer 231.

In contents in the sub-emission layer 220 and the active layer 231 may vary depending on growth temperatures, and a size of the energy band gap may vary depending on a difference in the In contents. For example, an In content of the third well layer 223a may be higher than those of the first and second well layers 221a and 222a due to growing the third well layer 223a at a temperature about 20°C lower than that of growing the first and second well layers 221a and 222a. The active layer 231 may be grown at a temperature lower than that of growing the third well layer 223a, and thus, the well layers 231a in the first well region 231c of the active layer 231 may have an In content higher than that of the third well layer 223a of the first sub-emission region 220a, and the well layers 231a in the second well region 231d of the active layer 231 may have an In content higher than that of the third well layer 223a of the second sub-emission region 220b.

Meanwhile, the In content may vary depending on a growth location of the nitride semiconductor layer, and in particular, a layer grown over the flat surface has higher In content than the layer grown in the V-pit 219v. Accordingly, the first, second, and third well layers 221a, 222a, and 223a of the second sub-emission region 220b grown in the V-pit 219v include smaller In content than the first, second, and third well layers 221a, 222a, and 223a, respectively. In addition, the second well region 231d of the active layer 231 grown in the V-pit 219v includes smaller In content than the first well region 231c grown on the flat surface.

Furthermore, although the second well region 231d of the active layer 231 is grown at a temperature lower than that of growing the sub-emission layer 220, since it is formed in the V-pit 219v, it may has smaller In content than the third well layer 223a of the first sub-emission region 220a. The In contents of the first and second well layers 221a and 222a of the first sub-emission region 220a may be smaller than those of the third well layer 223a of the first sub-emission region 220a and the first well region 231c of the active layer 231, and may be similar to that of the second well region 231d of the active layer 231.

Accordingly, considering the energy band diagram by comparing FIG. 6A and FIG. 6B, an energy band gap Eg11 of the third well layer 223a of the first sub-emission region 220a may be narrower than an energy band gap Eg16 of the second well region 231d, and may be wider than an energy band gap Eg12 of the first well region 231c. In addition, energy band gaps Eg9 and Eg10 of the first and second well layers 221a and 222a of the first sub-emission region 220a may be wider than the energy band gap Eg11 of the third well layer 223a of the first sub-emission region 220a and the energy band gap Eg12 of the first well region 231c, and may be similar to the energy band gap Eg16 of the second well region 331d.

The third well layer 223a of the first sub-emission region 220a may emit light having a wavelength shorter than that of the first well region 231c, and may emit light having a wavelength longer than those of the second well region 231d and the first and second well layers 221a and 222a of the first sub-emission region 220a.

FIG. 7 is a graph showing an electroluminescence (EL) intensity of the light emitting diode fabricated according to an exemplary embodiment of the present disclosure.

Here, the first well region 231c is formed of InₓAl_{y}Ga_{1-x-y}N (0≤x≤1, 0≤y≤1) so as to emit yellow light having a central wavelength of 560 nm to 590 nm, and the third well layer 223a is formed of InₓAl_{y}Ga_{1-x-y}N (0≤x≤1, 0≤y≤1) emitting blue or green light having a wavelength of 400 nm to 500 nm, which has an In content smaller than that of the first well region 231c, and greater than that of the second well region 231d. The second well region 231d and the first and second well layers 221a and 222a may emit blue light having a wavelength of 420 nm to 460 nm, and the third well layer 223a may emit blue or green light having a wavelength of 460 nm to 500 nm.

As shown in FIG. 7, the light emitting diode according to the illustrated exemplary embodiment has a smallest intensity at a peak wavelength of a shorter wavelength and a highest intensity at a peak wavelength of a longer wavelength among peak wavelengths. That is, as the peak wavelength increases, the intensity of emitted light increases. Meanwhile, a full width at half maximum of a spectrum of light emitted from the longer wavelength region, that is, a yellow region, may be larger than that of a spectrum of light emitted from other regions. In addition, a peak wavelength disposed in a middle among the three peak wavelengths may be closer to a shorter peak wavelength adjacent thereto than a longer peak wavelength adjacent thereto. Furthermore, valleys are formed between at the least three peak wavelengths, and a slope of a line connecting the valleys may be in a same direction as that of a line connecting intensities at the peak wavelengths. That is, as shown in FIG. 7, the line connecting the valleys has a increasing slope same as a slope of the line connecting the intensities at the peak wavelengths as the wavelength increases.

As such, by changing a growth temperature of at least one well layer of the sub-emission layer 220, the peak wavelength of the shorter wavelength region may be adjusted, and light having the at least three peak wavelengths may be implemented at a single chip level through at least two peak wavelengths of light emitted from the active layer 231 and at least one peak wavelength of light emitted from the sub-emission layer 220.

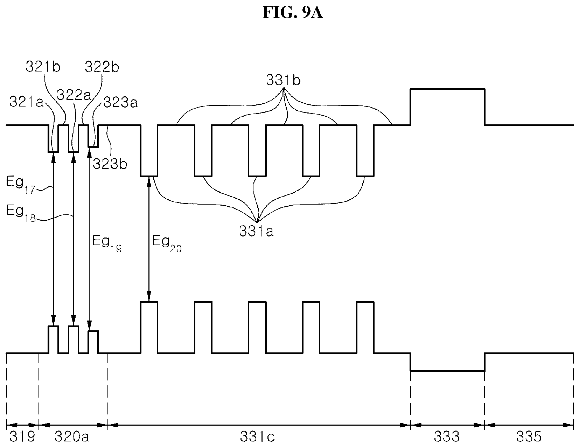

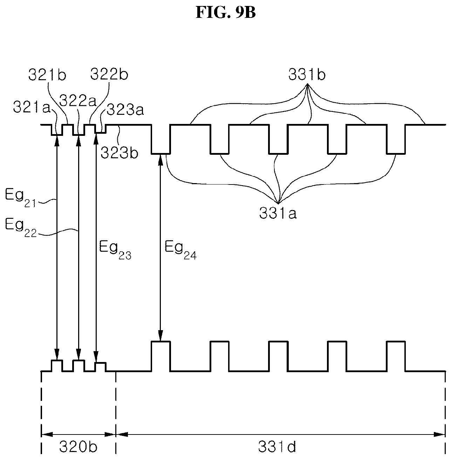

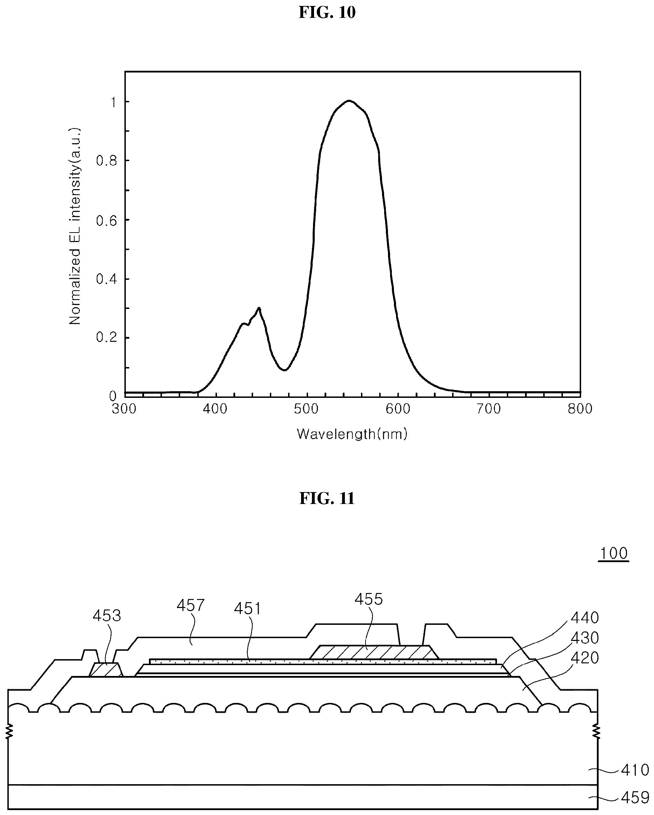

FIG. 8 is a cross-sectional view of a light emitting diode according to another exemplary embodiment, FIG. 9A and FIG. 9B are diagrams showing an energy band diagram of FIG. 8, and FIG. 10 is a graph showing optical characteristics of the light emitting diode according to the present exemplary embodiment.

Referring to FIG. 8, the light emitting diode according to the illustrated exemplary embodiment is similar to the light emitting diode of the exemplary embodiment of FIG. 1 except that a third well layer 323a of a sub-emission layer 320 is grown at a growth temperature higher than that of growing the third well layer 123a of the sub-emission layer 120. The light emitting diode according to the illustrated exemplary embodiment, which is similar to the light emitting diode of the embodiment of FIG. 1, may include a V-pit generation layer 319, an active layer 331, a sub-emission layer 320, an electron blocking layer 333, and a p-type nitride-based semiconductor layer 335. In addition, although not shown, the light emitting diode may include a substrate, a nucleation layer, a high-temperature buffer layer, and an n-type nitride semiconductor layer. The active layer 331 may include a well layer 331a and a barrier layer 331b, and the sub-emission layer 320 may include first through third well layers 321a, 322a, and 323a and capping layers 321b, 322b, and 323b. In an exemplary embodiment, the sub-emission layer 320 may include the first well layer 321a in contact with the V-pit generation layer 319, the third well layer 323a in contact with the active layer 331, and the second well layer 322a disposed between the first well layer 321a and the third well layer 323a.

The sub-emission layer 320 may be grown at a temperature relatively lower than that of growing the V-pit generation layer 319, and may be grown at a temperature relatively higher than that of growing the active layer 331. In detail, the sub-emission layer 320 may be grown at 700 °C to 800 °C. The sub-emission layer 320 may have various energy band gaps depending on growth temperatures. In addition, a growth temperature of at least one of the first, second, and third well layers 321a, 322a, and 323a may be different from those of the other well layer. For example, the third well layer 323a may be grown at a temperature about 10°C higher than that of growing the first and second well layers 321a and 322a.

Referring to FIGS. 9A and 9B, FIG. 9A shows an energy band diagram of a first sub-emission region 320a of the sub-emission layer 320 grown on a flat surface of the V-pit generation layer 319 and a first well region 331c of the active layer 331, and FIG. 9B shows an energy band diagram of a second sub-emission region 320b of the sub-emission layer 320 grown in a V-pit 319v and a second well region 331d of the active layer 331.

Energy band gaps of the sub-emission layer 320 and the active layer 331 may vary depending In contents, and the In contents may vary depending on growth temperatures and growth locations. For example, an In content of the third well layer 323a may be smaller than those of the first and second well layers 321a and 322a due to growing the third well layer 323a at a temperature about 10 °C higher than that of growing the first and second well layers 321a and 322a. In addition, due to the relatively low growth temperatures, In contents of the first and second well layers 321a and 322a may be greater than that of the third well layer 323a, and may be smaller than that of the first well region 331c. In addition, the In contents of the first and second well layers 321a and 321b of the first sub-emission region 320a may be similar to that of the second well region 331d.

Although the second well region 331d of the active layer 331 is grown at a temperature lower than that of growing the first and second well layers 321a and 321b, since it is grown in the V-pit 319v, the In content of the second well region 331d of the active layer 331 may be similar to those of the first and second well layers 321a and 321b.

Looking at the energy band diagram by comparing FIGS. 9A and 9B, an energy band gap Eg19 of the third well layer 323a of the first sub-emission region 320a may be wider than energy band gaps Eg17 and Eg18 of the first and second well layers 321a and 322a and energy band gaps Eg20 and Eg24 of the active layer 331. In addition, the energy band gaps Eg17 and Eg18 of the first and second well layers 321a and 322a of the first sub-emission region 320a may be narrower than the energy band gap Eg19 of the third well layer 323a of the first sub-emission region 320a may be wider than the energy band gap Eg20 of the first well region 331c, and may be similar to the energy band gap Eg24 of the second well region 331d.

The third well layer 323a of the first sub-emission region 320a may have a composition for emitting light having a wavelength shorter than those of the first and second well layers 321a and 322a and the active layer 331.

FIG. 10 is a graph showing an electroluminescence (EL) intensity of the light emitting diode fabricated according to an exemplary embodiment of the present disclosure.

Here, the first well region 331c is formed of InₓAl_{y}Ga_{1-x-y}N (0≤x≤1, 0≤y≤1) so as to emit yellow light having a central wavelength of 560 nm to 590 nm, and the third well layer 323a is formed of InₓAl_{y}Ga_{1-x-y}N (0≤x≤1, 0≤y≤1) emitting blue light having a wavelength of 400 nm to 500 nm, which has smaller In content than the first and second well layers 321a and 322a and the second well region 331d._ The third well layer 323a may emit blue light having a wavelength of 420 nm to 440 nm, and the first and second well layers 321a and 322a and the second well region 331d may emit blue light having a wavelength of 440 nm to 460 nm.

As shown in FIG. 10, the light emitting diode according to the illustrated exemplary embodiment has a smallest intensity at a peak wavelength of a shorter wavelength and a highest intensity at a peak wavelength of a longer wavelength among peak wavelengths. That is, as the peak wavelength increases, the intensity of emitted light increases. In addition, a spectrum of the shorter wavelength region may have a left-right asymmetric shape, and may have a shape in which a slope of the shorter wavelength side is smaller than that of the longer wavelength side with respect to the peak wavelength. Meanwhile, a full width at half maximum of a spectrum of light emitted from the longer wavelength region, that is, a yellow region, may be larger than that of a spectrum of light emitted from other regions.

As such, by changing a growth temperature of at least one well layer of the sub-emission layer 320, the peak wavelength of the shorter wavelength region may be adjusted, and light having at least three peak wavelengths may be implemented at a single chip level through at least two peak wavelengths of light emitted from the active layer 331 and at least one peak wavelength of light emitted from the sub-emission layer 320. Furthermore, the two peak wavelengths of the active layer 331 may emit white light through a combination of wavelengths of yellow light and blue light and blue light emitted from the sub-emission layer 320. The white light may be displayed as white light having a correlated color temperature (CCT) within a range of 3000K to 7000K, and the CCT may be adjusted depending on an intended use.

FIG. 11 is a schematic cross-sectional view illustrating a lateral type light emitting device 100 according to an exemplary embodiment.

Referring to FIG. 11, the light emitting device 100 according to the illustrated exemplary embodiment may include a substrate 410, an n-type semiconductor layer 420, an active layer 430, a p-type semiconductor layer 440, an ohmic electrode 451, an n-type electrode 453, a p-type electrode 455, a light transmitting layer 457, and a reflection film 459. In the illustrated exemplary embodiment, the n-type semiconductor layer 420 may include the nucleation layer, the high-temperature buffer layer, and the n-type nitride semiconductor layer described with reference to FIG. 1. In addition, the active layer 430 may include the sub-emission layer and the active layer as described with reference to FIG. 1, FIG. 5, or FIG. 8. In addition, in the illustrated exemplary embodiment, the p-type semiconductor layer may include the electron blocking layer and the p-type nitride semiconductor layer described with reference to FIG. 1. That is, the light emitting device 100 according to the illustrated exemplary embodiment includes the ohmic electrode 451, the n-type electrode 453, the p-type electrode 455, the light transmitting layer 457, and the reflection film 459 in addition to the elements of the light emitting diodes described with reference to FIG. 1, FIG. 5, or FIG. 8.

The light emitting device 100 includes a light emitting diode having a spectrum of multi-bands described above, and has a lateral structure. The p-type semiconductor layer 440 and the active layer 430 may be partially removed through an etching process, the n-type semiconductor layer 420 may be exposed, and the n-type electrode 453 may be formed on the exposed the n-type semiconductor layer 420. Meanwhile, the ohmic electrode 451 may be in ohmic contact with the p-type semiconductor layer 440, and the p-type electrode 455 may be formed on the ohmic electrode 451. The light transmitting layer 457 may cover upper portions and side surfaces of the n-type semiconductor layer 420, the active layer 430, and the p-type semiconductor layer 440. The light transmitting layer 457 may have openings exposing the n-type electrode 453 and the p-type electrode 455.

The light transmitting layer 457 may be formed of a single layer, without being limited thereto, or may include a multi-layer. The light transmitting layer 457 may include a light transmitting insulating oxide film such as SiO₂, SiNx, Al₂O₃, Nb₂O₅, TiO₂, MgF₂, or the like.

The reflection film 459 may be disposed on a lower portion of the substrate 410 opposite to the light transmitting layer 457. The reflection film 459 may include a distributed Bragg reflector or a metal reflector.

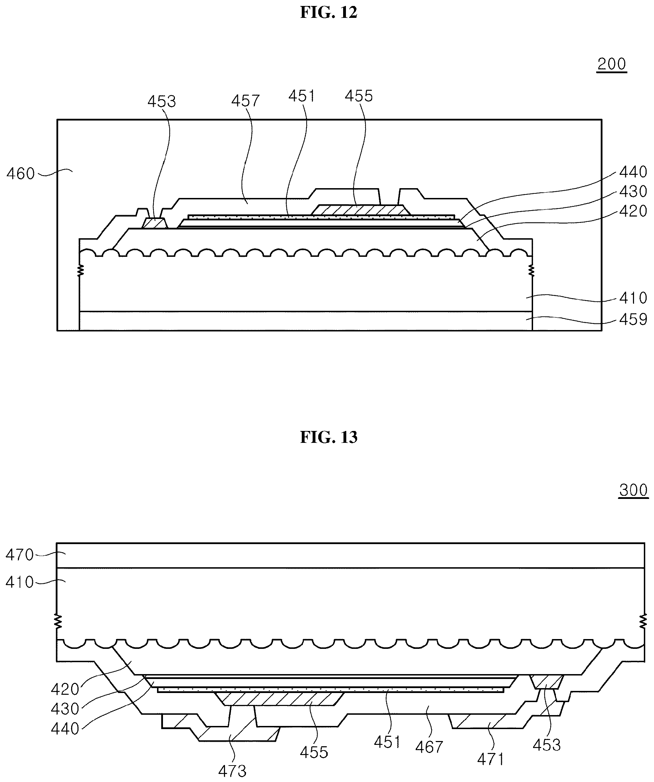

FIG. 12 is a schematic cross-sectional view illustrating a lateral type light emitting device 200 according to another exemplary embodiment.

The light emitting device 200 according to the illustrated exemplary embodiment has a structure substantially similar to that of the light emitting device 100 described with reference to FIG. 11, except that it further includes a second light transmitting layer 460.

In more detail, the lateral type light emitting device of FIG. 12 includes a first light transmitting layer 457 and a second light transmitting layer 460. The first light transmitting layer 457 may be identical to the light transmitting layer 457 described with reference to FIG. 11, and the second light transmitting layer 460 may include an epoxy molding compound (EMC), polyimide, or a material such as silicone, or the like. The second light transmitting layer 460 may have a structure different from that of the first light transmitting layer 457, may be formed in an upper portion of the substrate 410, and may cover a side surface of the substrate 410 as well as the upper portion thereof, as shown in FIG. 12.

In FIG. 11, the light transmitting layer 457 may be formed of a multi-layer, or as in FIG. 12, a multi-layered light transmitting layer may be formed by additionally forming the second light transmitting layer 460 on the first light transmitting layer 457. When the light transmitting layer is formed of the multi-layer, the light transmitting layer may include an anti-reflective coating (AR). The multi-layer may include, for example, a metal oxide such as SiO₂, Al₂O₃, HfO₂, Y₂O₃, TiO₂ or a metal fluoride such as MgF₂, CaF₂, LaF₃, or Na₃AlF₆.

The anti-reflective coating may be designed in consideration of a peak wavelength of light generated in the active layer 430. First, to increase an extraction efficiency of the peak wavelength of light generated in the active layer 430, the anti-reflective coating may be designed such that a transmittance in a corresponding peak wavelength band is close to 100%. In addition, the anti-reflective coating may be designed so as to have high transmittance for light generated in the active layer 430 as well as light of a shorter wavelength band and a longer wavelength band of visible light so as to improve CRI.

FIG. 13 is a schematic cross-sectional view illustrating a flip-chip type light emitting device 300 according to another exemplary embodiment.

Referring to FIG. 13, the light emitting device 300 according to the illustrated exemplary embodiment is substantially similar to the light emitting device 100 described with reference to FIG. 11, but it further includes an n-type bump electrode 471 and a p-type bump electrode 473, and locations of a light transmitting layer 470 and a reflection film 467 are different from those of the light transmitting layer 457 and the reflection film 459.

The light transmitting layer 470 is disposed on the substrate 410 to be opposite to the n-type semiconductor layer 420, and the reflection film 467 covers the n-type semiconductor layer 420, the p-type semiconductor layer 440, the ohmic electrode 451, the n-type electrode 453, and the p-type electrode 455. In addition, the reflection film 467 has openings exposing the n-type electrode 453 and the p-type electrode 455.

The n-type bump electrode 471 is electrically connected to the n-type electrode 453 through the opening of the reflection film 467, and the p-type bump electrode 473 is electrically connected to the p-type electrode 455 through the opening of the reflection film 467.

The light emitting device 300 may be flip-bonded on a circuit board using the n-type bump electrode 471 and the p-type bump electrode 473. Meanwhile, light generated in the active layer 430 may be emitted to the outside through the substrate 410 and the light transmitting layer 470.

A material of the light transmitting layer 470 is not particularly limited, and may include, for example, an epoxy molding compound (EMC), polyimide, silicone, or the like. In addition, the light transmitting layer 470 may contain a red phosphor so as to improve CRI of white light. The red phosphor may improve CRI of white light by wavelength-converting a portion of light generated in the light emitting devices 300 into red light.

The light-transmitting layer 470 may be formed of an identical material as those of the light-transmitting layers 457 and 460 as described with reference to FIG. 11 or FIG. 12. The light transmitting layer 470 may also cover a side surface of the substrate 410 as well as an upper surface thereof.

An outer surface of the light transmitting layer 470 may be formed to be substantially identical to an outer surface of the substrate 410. The light transmitting layer 470 may have a flat upper surface along a surface in contact with the substrate 110, and may be formed to have a constant thickness.

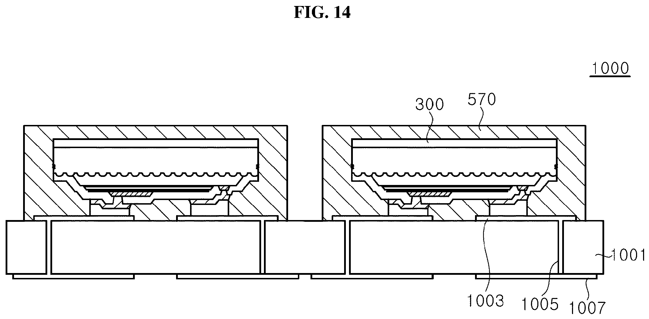

FIG. 14 is a schematic cross-sectional view illustrating a light emitting module 1000 according to an exemplary embodiment.

Referring to FIG. 14, the light emitting module 1000 may include a circuit board 1001, light emitting devices 300, and a light transmitting layer 570.

The circuit board 1001 has a circuit pattern for supplying power to the light emitting devices 300. For example, interconnections 1003 may be disposed on an upper surface of the circuit board 1001, pads 1007 may be disposed on a lower surface of the circuit board 1001, and the interconnections 1003 and the pads 1007 may be connected through vias 1005. The circuit board 1001 may include circuit patterns of multi-layers.

The light emitting devices 300 may be mounted on the circuit board 1001. The light emitting devices 300 may be flip-chip type light emitting devices as those described with reference to FIG. 13, without being limited thereto. For example, in the light emitting device 300, the light transmitting layer 470 may be omitted.

The light emitting device 300 may be bonded to the interconnections 1003 of the circuit board 1001 using the n-type bump electrode 471 and the p-type bump electrode 473. A plurality of light emitting devices 300 may be disposed on the circuit board 1001 in various arrangements. The light emitting devices 300 may be connected to one another in series or in parallel using the interconnections 1003 on the circuit board 1001, and may be electrically connected to the interconnections 1003 on the circuit board 1001 so as to enable individual driving.

The light transmitting layer 570 may cover an upper surface and a side surface of the light emitting device 300. As shown in FIG. 14, each of the light emitting devices 300 may be individually covered with the light transmitting layer 570, without being limited thereto, or one light transmitting layer 570 may cover the plurality of light emitting devices 300.

A material of the light transmitting layer 570 is not particularly limited, and may include, for example, an epoxy molding compound (EMC), polyimide, silicone, or the like. In addition, the light transmitting layer 570 may contain a red phosphor so as to improve CRI of white light. The red phosphor may improve CRI of white light by wavelength-converting a portion of light generated in the light emitting devices 300 into red light.

The light transmitting layer 570 may include a flat upper surface and a side surface vertical to the upper surface. The upper surface of the light transmitting layer 570 in contact with the upper surface of the light emitting device 300 may be formed to have a constant thickness. However, although not shown, an outer surface of the light transmitting layer 570 may be curved. A shape of the curved surface may be a form in which a width thereof is gradually narrowed from a bottom surface to a top surface in cross-sectional view, and may be in a form of an outer surface in which a slope of a tangent to the outer surface changes.

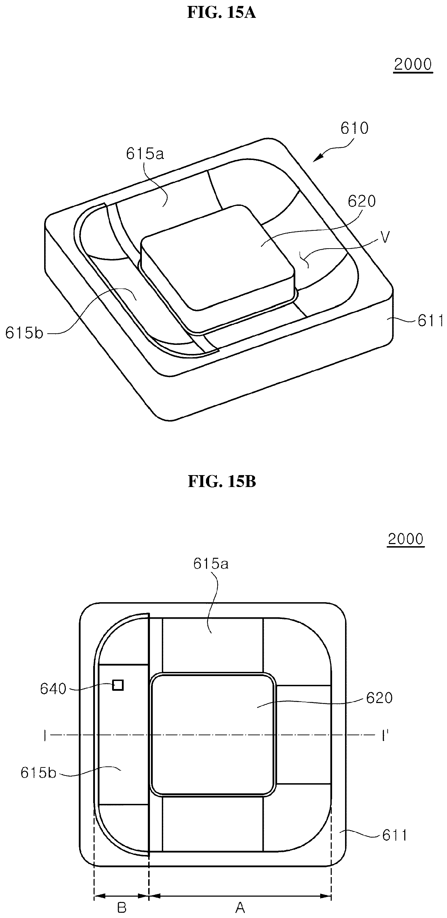

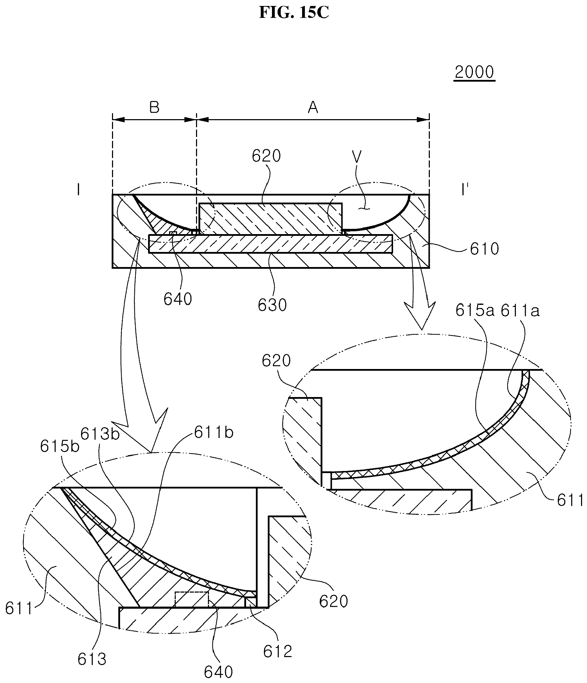

FIG. 15A is a perspective view illustrating a light emitting device package 2000 to which a light emitting diode according to an exemplary embodiment is applied, FIG. 15B is a plan view of FIG. 15A, and FIG. 15C is a cross-sectional view taken along line I-I' of its corresponding plan view shown in FIG. 15B.

Referring to FIG. 15A, FIG. 15B, and FIG. 15C, the light emitting device package 2000 may include a housing 610, a light emitting device 620, a lead frame 630, and a Zener diode 640.

In the illustrated exemplary embodiment, the housing 610 includes a body 611, a cover 613, and a coating portion 615. The body 611, as illustrated, may have a substantially quadrangular shape in plan view, and may have a shape surrounding the lead frame 630 so as to support the lead frame 630. The housing 610 may have a cavity V with one surface open therein, and the light emitting device 620 may be disposed in the cavity V.

Here, a depth of the cavity V may be greater than a height of the light emitting device 620. In this case, as shown in FIG. 15B and FIG. 15C, the body 611 may be divided into a region A and a region B. The region A may be a region in which the light emitting device 620 is mounted, and the region B may be a region in which the Zener diode 640 is mounted.

Looking at the region A of the body 611, inclined surfaces of the cavity V surrounding the light emitting device 620 may have an identically inclined surface with respect to the light emitting device 620. In this case, a first body inclined surface 611a formed in the region A may be formed as a curved surface, as shown in FIG. 15C, and may be formed such that an inclination of the curved surface becomes steeper toward an upper portion thereof.

The first body inclined surface 611a formed in the region A is formed on the cavities V of three surfaces of the light emitting device 620 except for one surface of the light emitting device 620. In this case, an inner side of the first body inclined surface 611a may be disposed near a location where the light emitting device 620 is mounted. Accordingly, light emitted from the light emitting device 620 may be reflected from the first body inclined surface 611a to be emitted upward the light emitting device package 2000.

And, as shown in FIG. 15C, a second body inclined surface 611b formed in the region B may have a straight line in cross-sectional view in the illustrated exemplary embodiment. However, when the first body inclined surface 611a is formed as the inclined surface, the cross-sectional shape of the second body inclined surface 611b is not limited to the straight line, or may be formed as a curved shape.

As it can be seen in FIG. 15B, a width of the region B in a longitudinal direction may be greater than a width of the region A in the longitudinal direction. Accordingly, a space in which the cover 613 is formed so as to cover the second body inclined surface 611b may be secured. This will be described in detail later.

Although not shown, in another exemplary embodiment, the first body inclined surface 611a and the second body inclined surface 611b of the body 611 may be in an inclined linear form, and a step portion having a flat surface may be formed in a middle of the inclined linear form. A corner may be formed at a point where a inclined linear cavity surface and the step portion meet. Since an area of an inner inclined surface of the cavity V is increased through this, a bonding area with an encapsulant filling the inside of the cavity V is increased and a moisture permeation path is lengthened, and thus, reliability of the device may be improved. In addition, when the encapsulant is formed in a form of double molding, a first formed encapsulant contacts the corner and is formed to have an elevation not exceeding the corner due to surface tension, and a secondary encapsulant may be formed from an upper portion of the first formed encapsulant to an elevation of the body 611.

The cover 613 is disposed so as to cover the second body inclined surface 611b formed in the region B, as shown in FIG. 15C. The cover 613 is formed to have a thickness sufficient to cover the Zener diode 640 disposed in the region B, and is formed not to exceed a stepped portion 612. And, the cover 613, as illustrated, may have a cover inclined surface 613b formed as a gently inclined surface. The cover inclined surface 613b may be formed as a curved surface, and may be formed so as to have a gently inclined surface from an upper portion to a lower portion.

Although the cover portion 613 has been described as being formed so as not to exceed the stepped portion 612, without being limited thereto, a portion of the cover 613 may be formed beyond the stepped portion 612 to a location where the light emitting device 620 is mounted, if necessary. That is, the cover 613 may be formed so as to cover the second body inclined surface 611b and the Zener diode 640 using a viscous material including a reflective material. In this case, the reflective material may be TiO₂, Al₂O₃, or the like.

As the cover 613 is formed in the region B, the cover inclined surface 613b formed in the cavity V of the light emitting device package 2000 may be formed in a shape similar to that of the first body inclined surface 611a. Accordingly, all surfaces of a reflection surface formed in the cavity V may be formed to be substantially identical with respect to the light emitting device 620.

The coating portion 615 is formed so as to cover the first body inclined surface 611a and the cover inclined surface 613b using a coating material including a reflective material. In this case, the reflective material may be TiO₂, Al₂O₃, or the like. That is, the coating portion 615 may be formed so as to cover an entire region except for the light emitting device 620 in the cavity V of the light emitting device package 2000. To this end, an upper portion of the light emitting device 620 is masked, and the coating portion 615 may be formed on the first body inclined surface 611a and the cover inclined surface 613b in an upper portion of the cavity V of the light emitting device package 2000 using methods such as spraying, dispensing, jetting, film attaching, sputtering, e-beam deposition, and the like. Accordingly, a first coating inclined surface 615a may be formed in the region A of the cavity V of the light emitting diode package 2000, and a second coating inclined surface 615b may be formed in the region B.

An encapsulant for protecting the light emitting device 620 may be formed in a cavity region of the light emitting device package 2000. The encapsulant may be formed of a light-transmitting material, and for example, a material such as silicone may be used. To implement white light with improved CRI, a red phosphor may be included in the encapsulant. Examples of a phosphor emitting light in a red wavelength region may include a nitrogen-containing aluminosiliconcalcium(CASN or SCASN)-based phosphor (e.g., (Sr, Ca)AlSiN₃:Eu). In addition, a manganese-activated fluoride-based phosphor (a phosphor represented by General Formula (I) A₂[M₁₋ₐMnₐF₆]). However, in General Formula (I), A is at least one selected from a group consisting of K, Li, Na, Rb, Cs and NH₄, M is at least one type of elements selected from a group consisting of a group 4 elements and a group 14 elements, and 0<a<0.2. A representative example of the manganese-activated fluoride-based phosphor is a phosphor of manganese-activated potassium silicon fluoride (e.g., K₂SiF₆:Mn). In addition, there is a manganese-activated phosphor (a phosphor represented by General Formula (II) (A_{4-aBa})_{m/2+n}/_{2X2m}[MX₄O₂]n) based on an oxiodohalide host lattice. However, in the General Formula (II), A is hydrogen (H) and/or deuterium (D), B is Li, Na, K, Rb, Cs, NH₄, ND₄, and/or NR₄, wherein R is an alkyl or aryl radical, X is F and/or Cl, M is Cr, Mo, W and/or Re, and 0 ≤ a ≤ 4, 0 < m ≤ 10, and 1 ≤ n ≤ 10.

In the illustrated exemplary embodiment, the light emitting device 620 may be a flip-chip type light emitting device similar to the flip-chip type light emitting device 300 of FIG. 13, without being limited thereto, or it may be a light emitting device similar to the lateral light emitting device 100 or 200 of FIG. 11 or FIG. 12. The light emitting device 620 may include the light emitting diode described with reference to FIG. 1, FIG. 5, or FIG. 8.

According to exemplary embodiments of the present disclosure, it is possible to provide a light emitting diode emitting light having multi-bands at a single chip level, and by using this, it is possible to implement various white light having a correlated color temperature within a range of 3000K to 7000K. Accordingly, a light emitting device or a light emitting module including the light emitting diode may be fabricated to provide a backlight light source, a general illumination light source, or an illumination light source for plant cultivation. According to exemplary embodiments of the present disclosure, light having a spectrum of a plurality of peak wavelengths from one light source may be supplied to a plant. That is, since it is possible to provide a light emitting diode that emits light having multi-bands within a region of the visible light, light having a similar spectrum to sunlight may be easily implemented using the light emitting diode. Furthermore, since the light emitting diode according to the illustrated exemplary embodiment may easily control an intensity of light of a plurality of bands, it is possible to provide a light source for plant cultivation by fabricating a light emitting diode emitting light of a wavelength band suitable for plant cultivation.

When used as the light source for plant cultivation, a power supply of the light source may be controlled according to a light cycle and a dark cycle of the plant. Therefore, it may stimulate a biological rhythm of the plant to promote growth, and in a case of a plant suitable for extracting an active substance, it may be effective to increase an amount of the active substance.

When a plurality of light sources is disposed, light sources with different color coordinates may be disposed. Since the light sources with different color coordinates have different stimuli of light provided to plants, they promote the growth of plants that have received various stimuli. In addition, the plurality of light sources may emit light having different peak wavelengths, and through this, plants may be supplied with light having various peak wavelengths, which may be effective in promoting their growth.

Although some exemplary embodiments have been described herein, it should be understood that these exemplary embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A light emitting diode, comprising:
an n-type nitride semiconductor layer;
a V-pit generation layer disposed on the n-type nitride semiconductor layer and having V-pits;
a sub-emission layer disposed on the V-pit generation layer and having a plurality of well layers and a plurality of capping layers;
an active layer disposed on the sub-emission layer and having a first well region formed along a flat surface of the V-pit generation layer and a second well region formed in the V-pit of the V-pit generation layer; and
a p-type nitride semiconductor layer disposed on the active layer, wherein:
an energy band gap of the sub-emission layer is wider than that of the first well region, and
the light emitting diode emits light having at least three different peak wavelengths at a single chip level.

2. The light emitting diode of claim 1,
wherein the sub-emission layer emits blue light or green light.

3. The light emitting diode of claim 2, wherein:
the plurality of well layers emits light having a peak wavelength within a region of wavelengths shorter than a peak wavelength of light emitted from the first well region, and
emits light having a peak wavelength within a region of wavelengths longer than a peak wavelength of light emitted from the second well region.

4. The light emitting diode of claim 2,
wherein the well layer of the sub-emission layer includes a first well layer, a second well layer, and a third well layer.

5. The light emitting diode of claim 4,
wherein energy band gaps of the first well layer, the second well layer, and the third well layer are substantially identical to one another, and wider than that of the first well region, and narrower than that of the second well region.

6. The light emitting diode of claim 4,
wherein at least one of the first through third well layers has an energy band gap different from those of other well layers.

7. The light emitting diode of claim 6, wherein:
the plurality of well layers emits light having a peak wavelength within the region of wavelengths longer than the peak wavelength of light emitted from the second well region, and
emits light having a peak wavelength within the region of wavelengths shorter than the peak wavelength of light emitted from the first well region.

8. The light emitting diode of claim 7,
wherein an energy band gap of the third well layer is narrower than those of the first well layer, the second well layer, and the second well region, and wider than that of the first well region.

9. The light emitting diode of claim 7,
wherein the energy band gap of the third well layer has an energy band gap wider than those of the first well layer, the second well layer, and the active layer.

10. The light emitting diode of claim 1,
wherein the active layer emits light having at least two different peak wavelengths at a single chip level.

11. The light emitting diode of claim 10,
wherein the first well region emits light having a peak wavelength within a region of wavelengths longer than that of light emitted from the second well region.

12. The light emitting diode of claim 11, wherein:
wherein the first well region emits yellow light, and
the second well region emits blue light.

13. A light emitting diode, comprising:
an n-type nitride semiconductor layer;
a V-pit generation layer disposed on the n-type nitride semiconductor layer and having V-pits;
a sub-emission layer disposed on the V-pit generation layer and having a plurality of well layers and a plurality of capping layers;
an active layer disposed on the sub-emission layer and having a first well region formed along a flat surface of the V-pit generation layer and a second well region formed in the V-pit of the V-pit generation layer; and
a p-type nitride semiconductor layer disposed on the active layer, wherein:
the light emitting diode emits light having at least three different peak wavelengths at a single chip level, and
an intensity of light at a peak wavelength disposed in a middle among the at least three different peak wavelengths is located between intensities of light at peak wavelengths disposed at both sides.

14. The light emitting diode of claim 13,
wherein the intensities at the at least three different peak wavelengths increase as the wavelength increases.

15. The light emitting diode of claim 13,
wherein the intensities at the at least three different peak wavelengths decrease as the wavelength increases.

16. The light emitting diode of claim 13,
wherein a full width at half maximum of an emission spectrum band including a longest wavelength among the at least three different peak wavelengths is greater than those of emission spectrum bands including other peak wavelengths.

17. The light emitting diode of claim 13,
wherein an emission spectrum band including a shortest wavelength among the at least three different peak wavelengths has a left-right asymmetric shape.

18. The light emitting diode of claim 13,
wherein a peak wavelength disposed in the middle among the at least three different peak wavelengths is closer to a shorter peak wavelength adjacent thereto than a longer peak wavelength adjacent thereto.

19. The light emitting diode of claim 13, wherein:
the at least three different peak wavelengths have a shortest peak wavelength and a longest peak wavelength, and
an intensity change as the wavelengths increase from the longest peak wavelength to the longer wavelength is more gradual than an intensity change as the wavelengths decrease from the shortest peak wavelength to the shorter wavelength.

20. The light emitting diode of claim 13, wherein:
at least two valleys are formed between the at least three different peak wavelengths, and
the at least two valleys may have different intensities from each other.
